Europäisches Patentamt

(19) European Patent Office

Office européen des brevets

(11) Numéro de publication : **0 162 514**
**B1**

(12) **FASCICULE DE BREVET EUROPÉEN**

(45) Date de publication du fascicule du brevet :
09.08.89

(21) Numéro de dépôt : **85200733.5**

(22) Date de dépôt : **10.05.85**

(51) Int. Cl.⁴ : **H 04 N 5/455**, H 03 D 3/24

(54) Démodulateur de fréquence à largeur de bande ajustable.

(30) Priorité : 15.05.84 FR 8407500

(43) Date de publication de la demande :
27.11.85 Bulletin 85/48

(45) Mention de la délivrance du brevet :
09.08.89 Bulletin 89/32

(84) Etats contractants désignés :
DE FR GB

(56) Documents cités :
GB—A— 2 101 432
US—A— 3 209 271
US—A— 4 261 016
PATENTS ABSTRACTS OF JAPAN, vol. 7, no. 13 (E-153) [1158], 19 janvier 1983 & JP - A - 57 171 808

(73) Titulaire : **LA RADIOTECHNIQUE PORTENSEIGNE**
**51, Rue Carnot**
**F-92150 Suresnes (FR)**
**FR**
**N.V. Philips' Gloeilampenfabrieken**
**Groenewoudseweg 1**
**NL-5621 BA Eindhoven (NL)**
**DE GB**

(72) Inventeur : **Hajj Chehade, Mohamed**
**SOCIETE CIVILE S.P.I.D. 209, Rue de l'Université**
**F-75007 Paris (FR)**

(74) Mandataire : **Caron, Jean et al**
**SOCIETE CIVILE S.P.I.D. 209, rue de l'Université**
**F-75007 Paris (FR)**

Jouve, 18, rue St-Denis, 75001 Paris, France

## Description

L'invention concerne un démodulateur de fréquence à largeur de bande ajustable en cours de fonctionnement, utilisé dans un récepteur d'images recevant entre autres des signaux de synchronisation, démodulateur du type à boucle d'asservissement de phase constituée essentiellement d'un comparateur de phase, d'un filtre, d'un oscillateur à fréquence commandée par une tension, et d'un amplificateur à gain réglable qui est inséré dans la boucle d'asservissement, et dont le gain est commandé par un signal de correction.

Un domaine d'application particulièrement intéressant d'un tel démodulateur est celui de la télédiffusion par satellite. Les émetteurs utilisés ont une puissance limitée et de ce fait les récepteurs doivent avoir une immunité au bruit aussi élevée que possible. La courbe représentant le rapport signal/bruit du signal démodulé par rapport au rapport signal/bruit du signal d'entrée présente une partie, pour un signal d'entrée peu bruité, dans laquelle les deux rapports évoluent de façon sensiblement proportionnelle. Par contre, au dessous d'un certain seuil, dit seuil de démodulation, le rapport signal/bruit du signal démodulé se détériore très rapidement lorsque le rapport signal/bruit du signal d'entrée diminue. Pour cette application le démodulateur à boucle d'asservissement est celui qui présente les meilleures performances de seuil de démodulation.

Cependant lorsque la réception est particulièrement mauvaise, un démodulateur de ce type procure une image dégradée par des nombreux points blancs ou noirs. Une réduction de la bande passante du démodulateur à mesure que le rapport signal/bruit se dégrade permet d'obtenir une image dont le contraste maximum diminue, mais dont le bruit est réduit dans une proportion telle que le résultat global est plus agréable.

Un démodulateur à boucle d'asservissement de phase dans lequel on fait varier le gain d'un amplificateur inséré dans la boucle en fonction du bruit dans le signal démodulé est décrit par le brevet US-A-3 209 271.

Dans ce démodulateur, la mesure du bruit est réalisée, en présence du signal utile, au moyen d'un filtrage dont la bande passante est située en dehors de celle du signal utile. De ce fait, le bruit mesuré n'est pas celui présent dans le signal utile, et la mesure est susceptible de donner des résultats faux, car il n'y a pas toujours une correspondance systématique entre les niveaux de bruit à différentes fréquences.

L'invention se propose d'améliorer encore les conditions de réception en prévoyant un nouveau moyen d'établissement du signal de correction.

A cet effet, le démodulateur selon l'invention est notamment remarquable en ce que le signal de correction est obtenu au moyen d'un circuit échantillonneur pour prélever au début d'un signal de synchronisation un échantillon de signal démodulé en sortie du démodulateur, muni d'un redresseur pour redresser le signal dudit échantillon, et d'un comparateur pour comparer le signal d'échantillon redressé à une tension continue prédéterminée, la sortie de ce comparateur fournissant le signal de correction.

Le dispositif selon l'invention présente l'intérêt de fournir une mesure particulièrement précise et fiable du bruit en sortie, puisqu'il mesure ce bruit pendant un instant (au début d'un signal de synchronisation de ligne ou de trame) où le signal est exclusivement composé de bruit, au lieu de chercher à mesurer le rapport signal/bruit en présence d'un signal utile.

Le démodulateur selon l'invention est avantageusement muni d'un diviseur de fréquence de trame, de façon à prélever un échantillon lors d'un seul signal de synchronisation de trame parmi une pluralité de tels signaux. Ainsi on évite une dégradation de l'image qui pourrait se produire si l'on effectuait une correction à chaque début de trame, à cause de phénomènes transitoires qui peuvent apparaître lors de la correction.

Dans un mode de réalisation particulier le démodulateur selon l'invention comporte une mémoire pour enregistrer la valeur du signal échantillonné redressé ou celle du signal de correction.

L'amplificateur à gain réglable est avantageusement constitué de deux voies en parallèles, l'une pour les fréquences les plus basses, et l'autre pour les fréquences les plus élevées, la voie destinée aux fréquences les plus élevées étant à gain réglable, alors que la voie destinée aux fréquences les plus basses est à gain fixe. Ainsi l'asservissement est maintenu en permanence pour les fréquences basses ou les dérives lentes, et la boucle ne risque pas de décrocher.

La description qui va suivre, en regard des dessins annexés décrivant des exemples non limitatifs fera bien comprendre comment l'invention peut être réalisée.

La figure 1 représente le schéma bloc d'un démodulateur selon l'invention.

La figure 2 représente un mode de réalisation de l'amplificateur à gain réglable.

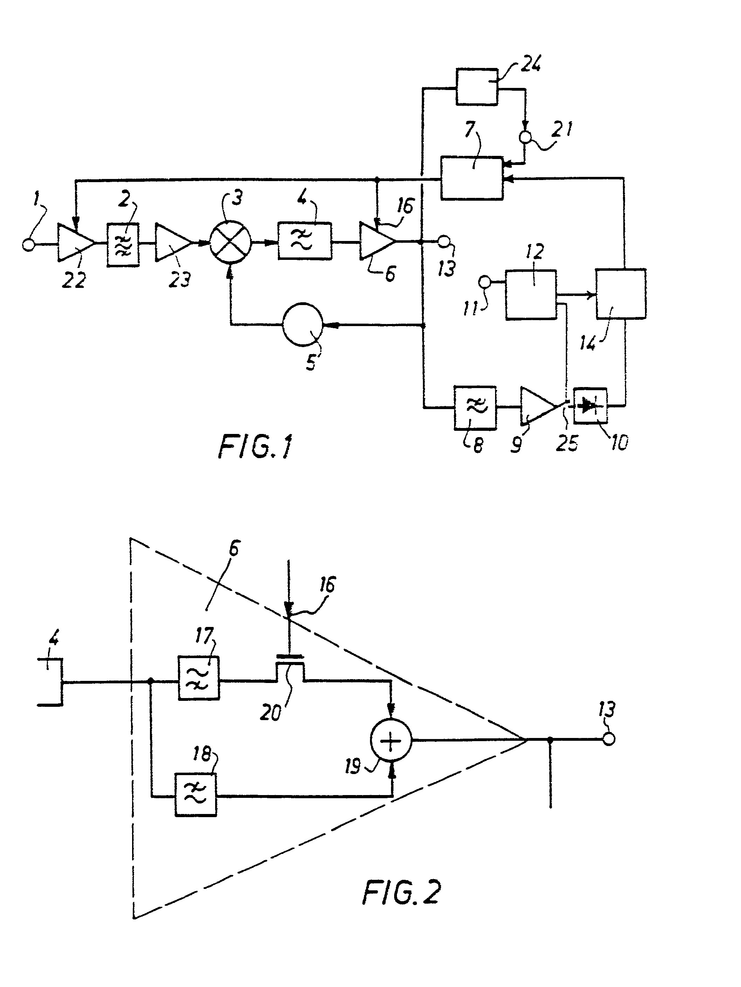

Le démodulateur de la figure 1 comporte une boucle d'asservissement de phase constituée essentiellement d'un comparateur de phase 3, d'un filtre 4 et d'un oscillateur à fréquence commandée par une tension 5.

Le signal à démoduler est amené sur la borne d'entrée 1. Il traverse un amplificateur à fréquence intermédiaire 22 à gain réglable, un filtre de fréquence intermédiaire 2, éventuellement un amplificateur linéaire 23, et est enfin amené à une entrée du comparateur de phase 3 dont l'autre entrée (inférieure, sur la figure) est reliée à la sortie de l'oscillateur à fréquence commandée 5. Le produit du comparateur de phase 3 est amené à l'entrée du filtre de boucle passe bas 4, traverse un amplificateur 6 qui sera étudié plus en détail ci-dessous et est enfin amené à la borne 13 de sortie du signal démodulé. Ce signal de sortie est en outre amené à l'entrée de commande de la fréquence de l'oscillateur 5 à fréquence commandée.

Le filtre à fréquence intermédiaire 2 est partie intégrante du démodulateur car la bande étroite de la boucle d'asservissement n'est pas suffisant, pour combattre le bruit. Ce filtre 2 doit être à bande assez large pour éviter une distorsion excessive, et assez étroite pour améliorer le seuil de démodulation. Une largeur de 30 Mhz est souhaitable. Pour une fréquence intermédiaire choisie, par exemple, à 441 Mhz, un filtre à ondes de surface est un bon choix.

Le détecteur de phase 3 est un mélangeur en anneau équilibré, réalisé au moyen de diodes Schottky afin d'obtenir une vitesse suffisante.

L'oscillateur 5 à fréquence commandée par une tension est un modèle à grande sensibilité, d'environ 22 Mhz/volt qui permet une grande largeur de bande de boucle sans distorsion significative.

Le démodulateur selon l'invention comporte un circuit échantillonneur 10, 12, 25 pour prélever au début d'un signal de synchronisation de trame appliqué à la borne 11, un échantillon du signal de sortie (13) du démodulateur, signal de sortie qui passe dans un filtre 8 et un amplificateur 9 et est redressé dans un circuit redresseur 10. Le filtre 8 et l'amplificateur 9 peuvent avantageusement être constitués par le filtre et l'amplificateur vidéo utilisés en général dans la partie vidéo d'un récepteur d'images.

Le signal de sortie de l'échantillonneur est appliqué via un circuit 14 qui sera expliqué plus loin à une entrée d'un comparateur 7 où il est comparé à une tension continue prédéterminée amenée sur une autre entrée 21. La valeur de cette tension continue est choisie de façon qu'elle soit pratiquement égale à la tension de bruit redressée issue normalement de l'échantillonneur lorsque le rapport signal/bruit du signal démodulé est de 30 dB. Ainsi, le comparateur ne fournit pas de signal de correction tant que le rapport signal/bruit est meilleur que 30 dB. La sortie de ce comparateur 7, qui fournit ainsi un signal de correction de la bande passante du démodulateur est relié à l'entrée de commande de gain 16 de l'amplificateur 6 à gain réglable inséré dans la boucle.

L'échantillonneur 10, 12, 25 fonctionne de la manière suivante : lors de l'arrivée d'une impulsion de trame sur la borne 11, le circuit 12 met en forme cette impulsion pour commander, pendant le laps de temps où il n'y a aucun signal vidéo et ou par conséquent on ne doit trouver que du bruit en sortie du démodulateur, la mise en route du circuit redresseur 10, par exemple par la fermeture d'une porte 25 disposée à l'entrée du circuit 10, afin de ne fournir un signal d'entrée à ce redresseur que pendant ledit laps de temps. La tension redressée lissée dans un condensateur peut être appliquée directement au comparateur 7. Il est toutefois préférable de mémoriser cette valeur afin qu'elle soit maintenue entre deux prises d'échantillon. C'est pourquoi la mémoire 14 est insérée entre la sortie du redresseur 10 et l'entrée du comparateur 7. L'instant d'enregistrement de la mémoire 14 est commandé également par le circuit de mise en forme 12. La mémoire 14 peut être constituée par un simple condensateur associé à des circuits d'adaptation d'impédance et/ou de porte, faciles à réaliser par l'homme du métier. Il peut aussi s'agir d'une mémoire numérique, auquel cas elle est précédée d'un convertisseur analogique/numérique et le comparateur 7 est lui aussi numérique, et suivi d'un convertisseur numérique/analogique.

Le circuit 12 contient aussi de préférence un diviseur de fréquence de trame. Les signaux de synchronisation de trame appliqués à l'entrée 11 sont comptés. et seulement un signal sur mille signaux, par exemple, est utilisé pour déclencher un échantillonnage. La fréquence de trame étant par exemple de 50 Hz, l'échantillonnage est effectué toutes les 20 secondes. Ceci a pour but d'éviter que des phénomènes transitoires consécutifs au réajustement du démodulateur puissent être visibles, ce qui pourrait être le cas s'ils se produisaient à chaque image.

La figure 2 montre un amplificateur à gain réglable 6, connecté entre la sortie du filtre de boucle 4 et la borne de sortie de signal démodulé 13. Cet amplificateur est constitué de deux voies en parallèle, l'une comportant un filtre passe bas 18 pour les fréquences les plus basses et l'autre comportant un filtre passe haut 17 pour les fréquences les plus élevées, et la voie destinée aux fréquences les plus élevées est à gain réglable grâce à un transistor FET 20 utilisé en résistance variable, alors que la voie destinée aux fréquences les plus basses est à gain fixe. Les signaux issus de ces deux voies sont ajoutés dans un circuit d'addition 19 et le signal somme est fourni en sortie 13. Le filtre de boucle 4 et le filtre passe haut 17 peuvent éventuellement être combinés en un seul filtre passe bande à la place du filtre 17. La séparation en deux voies permet un contrôle distinct du comportement statique et du comportement dynamique de la boucle, et permet d'obtenir ensemble une bonne stabilité et une bande vidéo large. Une largeur de bande de la boucle supérieure à 22 MHz est nécessaire dans les conditions normales (pour un rapport signal/bruit du signal d'entrée supérieur ou égal à 14 dB).

La voie réglable de l'amplificateur 6 est en pratique constituée d'une partie amplificatrice à gain fixe associée à un atténuateur variable 20.

Selon la figure 1 à nouveau, le signal de correction issu du comparateur 7 est également amené à l'amplificateur à fréquence intermédiaire 22 à gain réglable, pour le réglage de son gain. Lors de la dégradation du rapport signal/bruit la bande passante de l'ensemble est réduite par le réglage de l'amplificateur 22, alors que le réglage de l'amplificateur 6 augmente le coefficient d'amortissement de la boucle 3, 4, 5, 6.

Le bruit en dessous du seuil de démodulation apparaît sous la forme d'impulsions de décrochage, appelées aussi « cliks » d'amplitude et de largeur variées. Par la réduction de la largeur de bande de la boucle, le démodulateur évite beaucoup de cliks. La largeur minimale de bande de la boucle est ajustée à environ 10 MHz. Avec cette valeur, des images acceptables sont obtenues a partir d'un signal, d'entrée ayant un rapport porteuse/bruit de 2 dB seulement.

La tension continue prédéterminée appliquée à la borne 21 est avantageusement obtenue dans un circuit de mesure 24 et ajoutant une tension continue proportionnelle à la valeur du signal vidéo utile (c'est-à-dire du signal d'image en dehors des tops de synchronisation) et une tension continue constante de valeur prédéterminée fixe.

La majeure partie de la tension continue engendrée par le circuit 24 et appliquée à la borne 21 est cependant fixe, car en ajoutant les deux tensions, le circuit 24 introduit une pondération telle que la tension constante est prépondérante et la tension proportionnelle au signal vidéo représente au plus environ 10 % de la tension totale. Cette disposition a pour but de corriger le seuil de démodulation en fonction du contenu du signal (blanc/noir) pour tenir compte du fait que les cliks se voient plus dans le noir que dans le blanc.

. Il faut noter qu'un limiteur n'est pas nécessaire dans ce démodulateur, et que l'existence d'un dispositif limiteur, tel qu'un limiteur proprement dit ou un multiplieur de Gilbert, augmenterait le seuil de démodulation.

Un niveau de porteuse de OdBm à l'entrée du comparateur de phase donne une largeur de bande de boucle de 23 MHz environ, et pour — 15 dBm, celle-ci descend à 12 Mhz. Quand le rapport porteuse/bruit est très bas, 2 dB par exemple, la largeur est automatiquement réduite à 10 Mhz. Ainsi la qualité subjective de l'image se dégrade mais de manière non dramatique, comparée à un démodulateur ordinaire qui n'est pas utilisable à de tels niveaux de rapport signal/bruit.

Bien entendu des variantes peuvent être imaginées au schéma décrit ici à titre d'exemple, sans sortir du cadre de l'invention. Par exemple la porte 25 peut être placée ailleurs dans le trajet allant de la borne 13 à la mémoire 14, ou le signal de synchronisation de ligne peut être utilisé au lieu du signal de synchronisation de trame.

La mémoire 14 pourrait aussi être en aval du comparateur 7 pour mémoriser la tension de correction (qui serait alors établie transitoirement au début du signal de synchronisation trame) au lieu de mémoriser l'échantillon redressé servant à établir la comparaison.

**Revendications**

1. Démodulateur de fréquence à largeur de bande ajustable en cours de fonctionnement, utilisé dans un récepteur d'images recevant entre autres des signaux de synchronisation, démodulateur du type à boucle d'asservissement de phase constituée essentiellement d'un comparateur de phase, d'un filtre, d'un oscillateur à fréquence commandée par une tension, et d'un amplificateur à gain réglable qui est inséré dans la boucle d'asservissement, et dont le gain est commandé par un signal de correction, caractérisé en ce que le signal de correction est obtenu au moyen d'un circuit échantillonneur pour prélever au début d'un signal de synchronisation un échantillon de signal démodulé en sortie du démodulateur, muni d'un redresseur pour redresser le signal dudit échantillon, et d'un comparateur pour comparer le signal d'échantillon redressé à une tension continue prédéterminée, la sortie de ce comparateur fournissant le signal de correction.

2. Démodulateur selon la revendication 1, caractérisé en ce qu'il est muni d'un diviseur de fréquence de trame, de façon à prélever un échantillon lors d'un seul signal de synchronisation de trame parmi une pluralité de tels signaux.

3. Démodulateur selon l'une quelconque des revendications 1 ou 2, caractérisé en ce qu'il comporte une mémoire pour enregistrer la valeur du signal échantillonné redressé ou celle du signal de correction.

4. Démodulateur selon l'une quelconque des revendications 1 à 3, caractérisé en ce que, ledit amplificateur à gain réglable étant constitué de deux voies en parallèle, l'une pour les fréquences les plus basses et l'autre pour les fréquences les plus élevées, la voie destinée aux fréquences les plus élevées est à gain réglable, alors que la voie destinée aux fréquences les plus basses est à gain fixe.

5. Démodulateur selon l'une quelconque des revendications 1 à 4, comportant en outre, en amont du comparateur de phase dans le trajet d'amenée du signal à démoduler, un amplificateur à fréquence intermédiaire à gain réglable, caractérisé en ce que le signal de correction issu du comparateur est également amené audit amplificateur à fréquence intermédiaire pour le réglage de son gain.

6. Démodulateur selon l'une quelconque des revendications 1 à 5, caractérisé en ce que ladite tension continue prédéterminée utilisée dans le comparateur est obtenue dans un circuit de mesure (24) en ajoutant une tension continue proportionnelle à la valeur du signal vidéo utile et une tension continue constante de valeur prédéterminée fixe.

**Claims**

1. A frequency demodulator whose bandwidth can be adjusted during operation, used in a TV picture receiver receiving inter alia synchronizing signals, this demodulator being of the phase control loop type formed in essence by a phase comparator, a filter, a voltage-controlled oscillator and a variable-gain amplifier which is arranged in the control loop and whose gain is controlled by a correction signal, characterized in that the correction signal is obtained by means of a sampling circuit for taking a sample of the demodulated signal from the output of the demodulator at the start of a synchronizing signal, the sampling circuit comprising a rectifier for rectifying said sampling signal, and a comparator for comparing the rectified sampling signal with a predetermined d. c. voltage, the output of this comparator producing the correction signal.

2. A demodulator as claimed in Claim 1, characterized in that it comprises a field frequency divider, so as to take a sample during one single field synchronizing signal out of a plurality of such signals.

3. A demodulator as claimed in any one of the Claims 1 or 2, characterized in that it comprises a memory for storing the value of the rectified sampling signal or the value of the correction signal.

4. A demodulator as claimed in any one of the Claims 1 to 3, characterized in that said variable-gain amplifier is formed by two parallel paths, one for the lower frequencies and the other for the higher frequencies, the path intended for the higher frequencies having a variable gain, whilst the path intended for the lowest frequencies has a fixed gain.

5. A demodulator as claimed in any one of the Claims 1 to 4, comprising inter alia, upstream of the phase comparator in the path conveying the signal to be demodulated, a variable-gain intermediate-frequency amplifier, characterized in that the correction signal originating from the comparator is also conveyed to said intermediate-frequency amplifier for controlling its gain.

6. A demodulator as claimed in any one of the Claims 1 to 5, characterized in that said predetermined d. c. voltage used in the comparator is obtained in a measuring circuit (24) by adding together a d. c. voltage which is proportional to the value of the useful video signal and a constant d. c. voltage of a predetermined fixed value.

**Patentansprüche**

1. Frequenzdemodulator mit im Betrieb einstellbarer Bandbreite, zum Gebrauch in einem Bildempfänger, der u. a. Synchronsignale empfängt, wobei dieser Demodulator vom Phasenregelschleifentyp ist, der im wesentlichem durch eine Phasenvergleichsanordnung, ein Filter, einen spannungsgesteuerten Frequenzoszillator und einen in die Phasenregelschleife aufgenommenen Verstärker mit regelbarer Verstärkung gebildet ist, wobei die Verstärkung durch ein Korrektursignal gesteuert wird, dadurch gekennzeichnet, dass das Korrektursignal mit Hilfe einer Abtastwertschaltung erhalten wird, und zwar zum am Anfang eines Synchronsignals Erhalten eines Abtastwertes des demodulierten Signals an dem Ausgang des Demodulators, wobei die Abtastwertschaltung eine Gleichrichterschaltung aufweist zum Gleichrichten des Signals des genannten Abtastwertes, sowie eine Vergleichsschaltung zum Vergleichen des gleichgerichteten Abtastwertsignals mit einer vorbestimmten Gleichspannung, wobei der Ausgang dieser Vergleichsschaltung das Korrektursignal liefert.

2. Demodulator nach Anspruch 1, dadurch gekennzeichnet, dass er mit einem Teilbildfrequenzteiler versehen ist, so dass während eines einzigen Teilbildsynchronsignals aus einer Vielzahl derartiger Signale ein Abtastwert genommen werden kann.

3. Demodulator nach einem der Ansprüche 1 oder 2, dadurch gekennzeichnet, dass er einen Speicher zum Speichern des Wertes des gleichgerichteten Abtastwertsignals oder des Korrektursignals aufweist.

4. Demudulator nach einem der Ansprüche 1 bis 3, dadurch gekennzeichnet, dass der genannten Verstärker mit regelbarer Verstärkung aus zwei parallelen Strecken gebildet ist, wobei die eine für die tieferen Frequenzen und die andere für die höheren Frequenzen vorgesehen ist, wobei die Strecke für die höheren Frequenzen eine regelbare Verstärkung aufweist, während die Strecke für die tieferen Frequenzen eine feste Verstärkung hat.

5. Demodulator nach einem der Ansprüche 1 bis 4, mit u. a. stromaufwärts von der Phasenvergleichsschaltung in der Strecke, über die das zu demodulierende Signal fliesst, einem Demodulator, einem ZF-Verstärker mit regelbarer Verstärkung, dadurch gekennzeichnet, dass das von der Vergleichsschaltung herrührende Korrektursignal ebenfalls dem genannten ZF-Verstärker zur Regelung der Verstärkung desselben zugeführt wird.

6. Demodulator nach einem der Ansprüche 1 bis 5, dadurch gekennzeichnet, dass die genannte in der Vergleichsschaltung verwendete vorbestimmte Gleichspannung in einer Messschaltung (24) dadurch erhalten wird, dass eine zu dem Wert des nützlichen Video-Signals proportionelle Gleichspannung zu einer konstanten Gleichspannung mit einem vorbestimmten festen Wert addiert wird.

FIG.1

FIG.2